(19) Europäisches Patentamt
European Patent Office
Office européen des brevets

(11) **EP 0 706 227 B1**

(12) **EUROPEAN PATENT SPECIFICATION**

(45) Date of publication and mention
of the grant of the patent:
**10.03.1999 Bulletin 1999/10**

(51) Int Cl.⁶: **H01L 41/107**

(21) Application number: **95115732.0**

(22) Date of filing: **05.10.1995**

(54) **Piezoelectric transformer having high conversion efficiency**

Piezoelektrischer Transformator mit grosser Konvertierungsfähigkeit

Transformateur piezoélectrique à rendement de conversion élevé

(84) Designated Contracting States:
**DE FR GB IT NL**

(30) Priority: **05.10.1994 JP 241048/94**

(43) Date of publication of application:
**10.04.1996 Bulletin 1996/15**

(73) Proprietor: **NEC CORPORATION**
**Tokyo (JP)**

(72) Inventor: **Tagami, Satoru**
**Minato-ku, Tokyo (JP)**

(74) Representative: **Glawe, Delfs, Moll & Partner**
**Patentanwälte**
**Postfach 26 01 62**
**80058 München (DE)**

(56) References cited:
**EP-A- 0 555 887**

## Description

Background of the Invention

Field of the invention

The present invention relates to a piezoelectric transformer used for a small-sized high voltage power supply having a high reliability, and more particularly to such a piezoelectric transformer suitable as an inverter for a back-light of a crystal liquid display.

Description of related art

In most of cases, high voltage generating transformers used for a back-light of crystal liquid displays have been conventionally composed of electromagnetic solenoid transformers.

On the one hand, a piezoelectric transformer having an operation principle completely different from that of the electromagnetic solenoid transformer has been proposed. In US Patent 5,365,141 and its corresponding European Patent Application Laid-open Publication No. 0 555 887 A1, a piezoelectric transformer having possibility being used as an inverter for a back-light of a crystal liquid display, has been proposed according to the first part of present Claim 1.

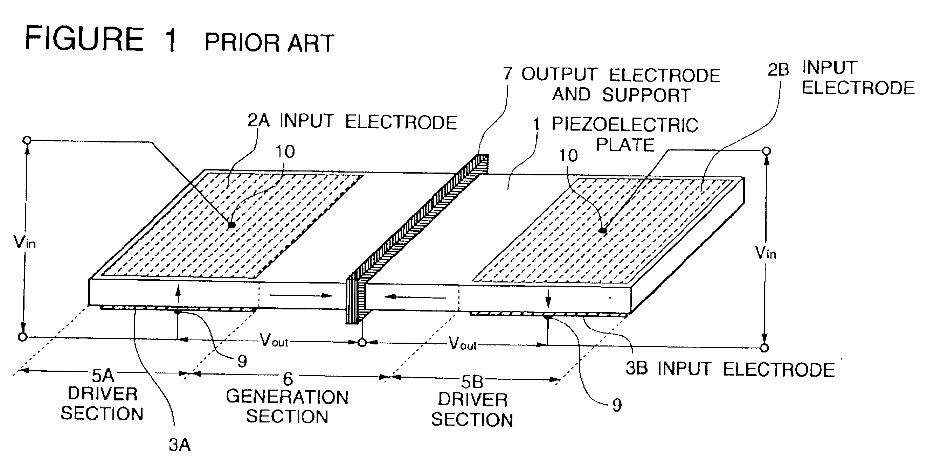

Referring to Figure 1, there is shown a diagrammatic perspective view of the piezoelectric transformer proposed in the US patent and European patent application mentioned above.

In Figure 1, the piezoelectric transformer is constituted of a piezoelectric plate 1 which is divided into a pair of driver sections (or input section) 5A and 5B and one generator section (or output section) 6 between the driver sections 5A and 5B. The piezoelectric transformer comprises a pair of electrodes 2A and 3A and 2B and 3B formed on an upper surface and a lower surface of each of the driver sections 5A and 5B, respectively. A terminal and support 7 is electrically soldered on an output electrode formed on the generator section 6 at a center position in a lengthwise direction. The piezoelectric transformer also comprises lower and upper electrode terminals 9 and 10 which are formed on the electrodes 2A and 3A and 2B and 3B of each of the driver sections 5A and 5B, respectively and which are positioned at a center position in a lengthwise direction of the driver sections 5A and 5B. In this figure, arrows depicted at a lengthwise front side surface of the piezoelectric plate 1 show a polarization direction. As shown by the arrows, the two generator sections 5A and 5B were polarized in a thickness direction but in directions opposite to each other. The generator section 6 was divided by a center transverse plane into two portions in length, and the two portions were polarized in a lengthwise direction but in an opposite direction to each other.

With this arrangement, alternating electrical current input voltages Vin having a third order mode resonant frequency of a longitudinal mechanical vibration in a lengthwise direction of the piezoelectric plate 1 but having a phase opposite to each other, are respectively applied between the pair of electrodes 2A and 3A of the driver section 5A and between the pair of electrodes 2B and 3B of the driver section 5B. As a result, the piezoelectric plate 1 cause a mechanical resonating, so that an output voltage Vout is obtained from the generator section 6, namely, between the output electrode 7.of the generator section 6 and the input electrode 3A of the driver section 5A and between the output electrode 7.and the input electrode 3B of the driver section 5B, in parallel to each other.

Namely, the AC input voltage applied between electrodes 2A and 3A of the driver section 5A is opposite in a phase to that applied between the electrodes 2B and 3B of the driver section 5B. On the other hand, the output voltage Vout between the output electrode 7.and the input electrode 3A of the driver section 5A and the output voltage Vout between the output electrode 7.and the input electrode 3B of the driver section 5B are combined in parallel to each other.

Thus, it has become possible to provide an inverter composed of a piezoelectric transformer having a small size and a small thickness which could not be realized in the conventional electromagnetic solenoid transformer.

However, the above mentioned piezoelectric transformer has the following disadvantages:

For example, since a large amount of light is required for back-lighting a color liquid crystal display, a cold cathode fluorescent lamp (abbreviated "CFL" hereinafter) is ordinarily used as a light source. Since this CFL has a high impedance on the order of 100 K$\Omega$, a stray capacitance Cst is created between the CFL and a metallic reflecting plate provided in proximity of the CFL so as to cover the CFL. This stray capacitance Cst is parasitic in parallel to the CFL, and can be estimated to be on the order of 10 pF for one CFL. Here, assuming that the third order mode resonant frequency of the piezoelectric transformer is on the order of 100 KHz, a synthesized impedance of the stray capacitance Cst and the CFL drops on the order of 61 K$\Omega$.

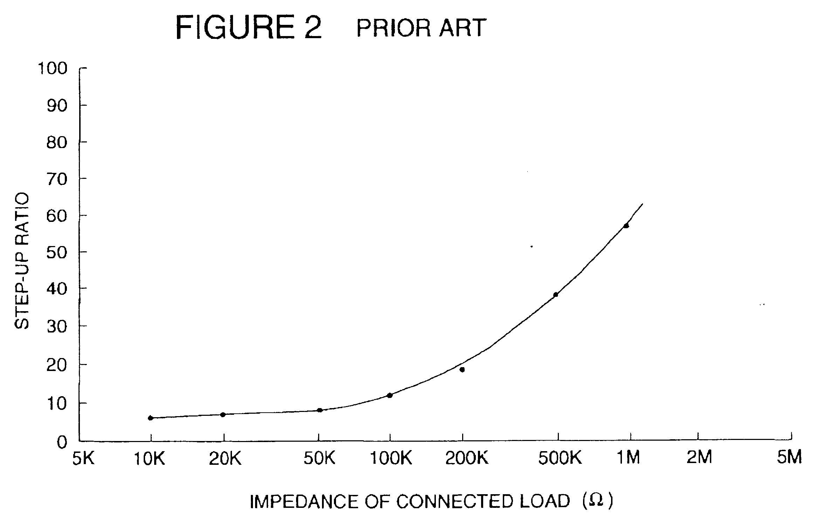

On the other hand, the output characteristics of the piezoelectric transformer changes dependently upon a load impedance connected to the piezoelectric transformer. Referring to Figure 2, there is shown one example of the output characteristics of the piezoelectric transformer disclosed in the above mentioned US patent and European patent application. As will be apparent from Figure 2, if the piezoelectric transformer is connected to a load having a high impedance on the order of 1 M$\Omega$, a high step-up ratio can be obtained, and therefore, a large output power can be obtained, and on the other hand, if the impedance of the load connected to the piezoelectric transformer is not greater than 100 K$\Omega$, the output greatly drops and the step-up ratio becomes not greater than 10.

In the present status, since an input voltage for the back light inverter is on the order of DC 12 V, the step-up ratio on the order of 10 times is entirely insufficient to obtain the output voltage on the order of 350 V required to light up the CFL. In order to solve this problem, for example,

(1) it can be considered to enlarge the input voltage of the piezoelectric transformer; or
(2) it can be considered to re-design the piezoelectric transformer, by taking for example a stacked system into a consideration.

In order to realize the first countermeasure (1), it is necessary to elevate the power of a voltage supply of an upper system of the back light inverter, for example, a personal computer; or to increase the number of step-up circuits provided before the piezoelectric transformer. However, the former approach is against a recent low voltage inclination in a field including an LSI (large scaled integrated circuit). The latter approach results in an increased number of parts and in a cost-up. In addition, the latter approach is against a down-sizing and thinning inclination of the inverter and hence the display, which should be realized for a down-sizing request for an overall system. Thus; the first countermeasure (1) will loss an industrial merit and therefore is not acceptable.

The second countermeasure (2) may be realized by stacking a required number of ceramic layers each having a film thickness on the order of a few 10 μm, by use of a green sheet method, so that it is possible to elevate an input electric field strength, whereby shortage of the step-up ratio is overcome and therefore a large output voltage can be obtained. However, a process for manufacturing a stacked type piezoelectric transformer in accordance with the green sheet method has not yet been established. In addition, the second countermeasure (2) would result in a cost-up. Accordingly, the second countermeasure (2) would not be practical. Alternatively, if the piezoelectric transformer is scaled up in place of adopting the stacked system, the industrial merit would be also lost, similarly to the first countermeasure (1).

Summary of the Invention

Accordingly, it is an object of the present invention to provide a piezoelectric transformer which has overcome the above mentioned problem of the conventional one.

Another object of the present invention is to provide a piezoelectric transformer having a high step-up ratio.

A still another object of the present invention is to provide a piezoelectric transformer having a high transformation ratio and a high transformation efficiency.

In order to overcome the above mentioned problem of the conventional piezoelectric transformer the present invention provides a new piezoelectric transformer according to claim 1. The dependent claims are related to further advantageous aspects of the present invention.

The piezoelectric transformer in accordance with the present invention provides the following means, which will be explained with reference to Figure 2 illustrating a dependency of the piezoelectric transformer output characteristics to a connected load impedance.

The load causing the output characteristics to start to abruptly elevate is called a matching load where the piezoelectric transformer output impedance matches with the load impedance. Namely, in order to improve the output characteristics of the piezoelectric transformer, it is sufficient if the following relation is satisfied:

output impedance < connected load impedance

In order to meet this requirement, the present invention proposes to reduce the piezoelectric transformer output impedance, so as to give no adverse influence onto the connected load.

Here, the output impedance $Z_2$,out of the piezoelectric transformer can be expressed as follows:

$$Z_2,\text{out} = 1/(C_{d2}\cdot\omega)$$

$$= 1/\{1-k_{33}^2)\cdot\varepsilon_o\cdot\varepsilon_r\cdot(W\cdot t/l_2)\cdot 2\cdot\pi\cdot f\} \qquad (1)$$

where

| | |
|---|---|
| $C_{d2}$ = | constraint capacitance of secondary side of piezoelectric transformer |
| $k_{33}$ = | electromechanical coupling coefficient in a *33* polarization direction of piezoelectric material |
| $\varepsilon_o$ = | vacuum permitivity |
| $\varepsilon_r$ = | relative permitivity of piezoelectric material |
| $W$ = | width of piezoelectric transformer |
| $t$ = | thickness of piezoelectric transformer |
| $l_2$ = | inter-electrode distance on of secondary side of piezoelectric transformer |
| $f$ = | driving frequency |
| $\omega$ = | driving angular frequency |

Therefore, it can be said from the above equation (1) that, by enlarging the width "W" of the piezoelectric transformer, it it possible to reduce the output impedance so as to improve the output characteristics.

Here, it may be considered that the output characteristics can be improved by enlarging t or f. However, if t is enlarged, the input electric field strength drops, or if f is enlarged, the impedance of the connected load such as the back-light is caused to drop because of the existence of Cst. From a total consideration, it can be said that the enlargement of t or *f* will not result in improvement of the output characteristics. In addition, since reduction of $I_2$ is equivalent to the enlargement of *f*, discussion thereof will be omitted.

From another viewpoint, with the enlargement of the width W, vibration in a widthwise direction becomes easy to be excited, in addition to the longitudinal vibration in a lengthwise direction. In other words, if the width W is enlarged, the longitudinal vibration or mechanical oscillation in the lengthwise direction is correspondingly weakened, and therefore, the output characteristics of the piezoelectric transformer also drops. Accordingly, it has been a conventional practice to maintain the ratio of "λ/2" and W in such a relation of "λ/2" : W > 1 : 0.5 (where "λ" is a resonance wavelength).

According to the invention as claimed, with the above mentioned advantage obtained from the reduced output impedance, even if 1 : 0.5 exceeds the ratio of "λ/2" and W, the output characteristics of the piezoelectric transformer call be improved. However, if 1 : 0.5 too greatly exceeds the ratio of "λ/2" and W, the output drops because of spurious oscillation. Therefore, an optimum range of the width "W" of the piezoelectric transformer is ought to exist.

A preferred transformer according to Claim 2 is characterized by, inter alia,

the at least one generator section being formed of a central region of the piezoelectric plate containing a mechanical resonance node in the above mentioned three or more odd number times oscillation mode,
the driver sections being polarized in a thickness direction,
the driver sections having a distance of λ/2 from the corresponding end of the piezoelectric plate, and
the ratio "R" of the width "W" of the piezoelectric plate to the resonance half wavelength "λ/2" being in the range of 0.5≤R≤0.8.

The above and other objects, features and advantages of the present invention will be apparent from the following description of preferred embodiments of the invention with reference to the accompanying drawings.

Brief Description of the Drawings

Figure 1 is a diagrammatic perspective view of the conventional piezoelectric transformer;
Figure 2 is a graph showing one example of the output characteristics of the conventional piezoelectric transformer shown in Figure 1;
Figure 3 is a diagrammatic perspective view of a first embodiment of the piezoelectric transformer in accordance with the present invention, having three times λ/2 mode;
Figure 4 is a graph showing a relation between the width and the conversion efficiency of the piezoelectric transformer shown in Figure 3;
Figure 5 is a graph showing a relation between the width and the step-up ratio of the piezoelectric transformer shown in Figure 3;
Figure 6A is a diagrammatic perspective view of a second embodiment of the piezoelectric transformer in accordance with the present invention.
Fig. 6B and 6C are cross-sections at positions B and A, respectively, of the transformer shown in Fig. 6A.

Description of the Preferred embodiments

The present invention will be described in detail in the following description of embodiments. Now, common points in the following embodiments are explained together.

(1) Material plate for the piezoelectric transformer

As a piezoelectric ceramic material having a large electromechanical coupling coefficient $k_{33}$ (in a polarization direction) and a large mechanical quality coefficient Qm, a sintered material available under the tradename NEPEC 8 from Torkin (Japanese Corporation) was used. This sintered material was cut into a desired form of an elongated plate.

(2) Formation of the electrodes

Electrodes were formed by patterning a silver paste by means of an usual thick film screen printing process and then by sintering the patterned electrodes at a temperature of 600°C.

(3) Polarization processing

In an insulating oil heated at a temperature of 150°C, a DC electric field of 1.5KV/mm is applied and maintained for 15 minutes.

(4) Installation of supports

A metallic material such as a blanked copper plate was electrically soldered at a position of the piezoelectric transformer material plate, which position corresponds to an oscillation node and is located at a half of the width of the piezoelectric transformer.

(5) Installation of terminals

A thin-plated copper wire was connected and fixed, by a spot-soldering, to a position of the piezoelectric transformer material plate, which position corresponds to an oscillation node and is located at a half of the width of the piezoelectric transformer.

Embodiment 1

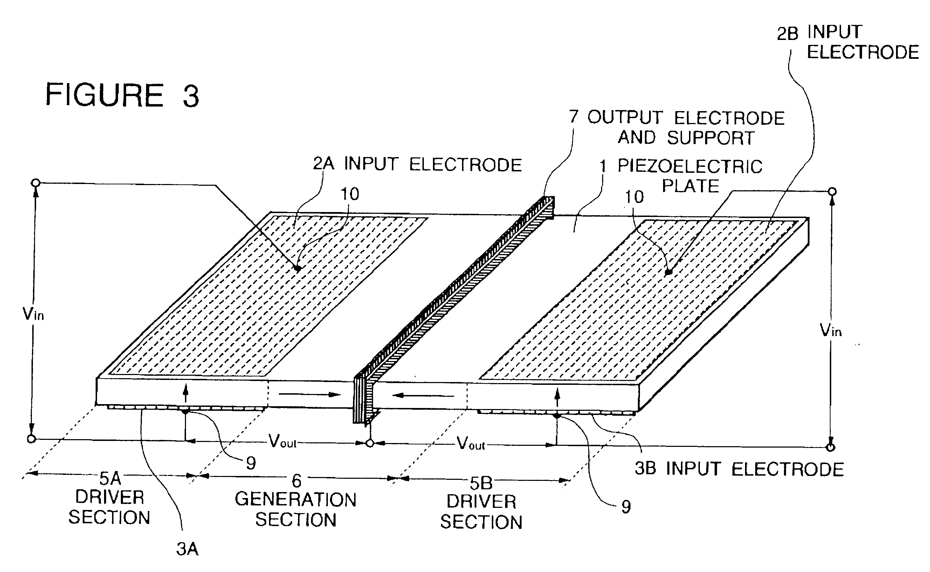

Referring to Figure 3, there is shown a diagrammatic perspective view of a first embodiment of the piezoelectric transformer in accordance with the present invention, having three times $\lambda/2$ mode. In Figure 3, elements similar to those shown in Figure 1 are given the same Reference Numerals.

A three times $\lambda/2$ mode piezoelectric transformer as shown in Figure 3 was manufactured. In Figure 3, the piezoelectric transformer is constituted of a piezoelectric plate 1 which is divided into a pair of driver sections (or input section) 5A and 5B and one generator section (or output section) 6 between the driver sections 5A and 5B. The piezoelectric transformer comprises a pair of electrodes 2A and 3A and 2B and 3B formed on an upper surface and a lower surface of each of the driver sections 5A and 5B, respectively. A terminal and support 7 is electrically soldered on an output electrode formed on the generator section 6 at a center position in a lengthwise direction. The piezoelectric transformer also comprises lower and upper electrode terminals 9 and 10 which are formed on the electrodes 2A and 3A and 2B and 3B of each of the driver sections 5A and 5B, respectively and which are positioned at a position which is a center in a widthwise direction of the piezoelectric plate 1 and which is at a distance of $\lambda/6$ from each end of the piezoelectric plate 1 (where $\lambda$ is a wavelength of a resonance frequency). Therefore, the output electrode 7 and the lower and upper electrode terminals 9 and 10 are located at respective nodes of a mechanical oscillation generated in the piezoelectric plate 1. In this figure, arrows depicted at a lengthwise front side surface of the piezoelectric plate 1 show a polarization direction. As shown by the arrows, the two generator sections 5A and 5B were polarized in a thickness direction and in the same direction as that of the other. The generator section 6 was divided by a center transverse plane into two portions in length, and the two portions were polarized in a lengthwise direction but in an opposite direction to each other.

With this arrangement, an input voltage Vin is applied between the pair of electrodes 2A and 3A of the driver section 5A and between the pair of electrodes 2B and 3B of the driver section 5B, and an output voltage Vout is obtained between the output electrode 7.and the input electrode 3A of the driver section 5A and between the output electrode 7.and the input electrode 3B of the driver section 5B.

All of the driver sections 5A and 5B formed at opposite end portions of the piezoelectric plate 1 and the generator section 6 shown in Figure 1 have a length of $\lambda/2$, and the piezoelectric plate 1 has a total length of 42 mm and a thickness of 1 mm.

The width "W" of the piezoelectric plate 1 was determined as follows:

First, assume that a back-light for a color liquid crystal display (23.9 cm (9.4 inches); one lamp) is connected to the piezoelectric transformer as a load. This back-light includes one CFL, a reflecting plate covering the CFL, and a light guiding plate. In addition, the back-light has an electric impedance of about 100 K$\Omega$ when the CFL is lighted to have a brightness of 2000 Cd/m$^2$ on the light guiding plate.

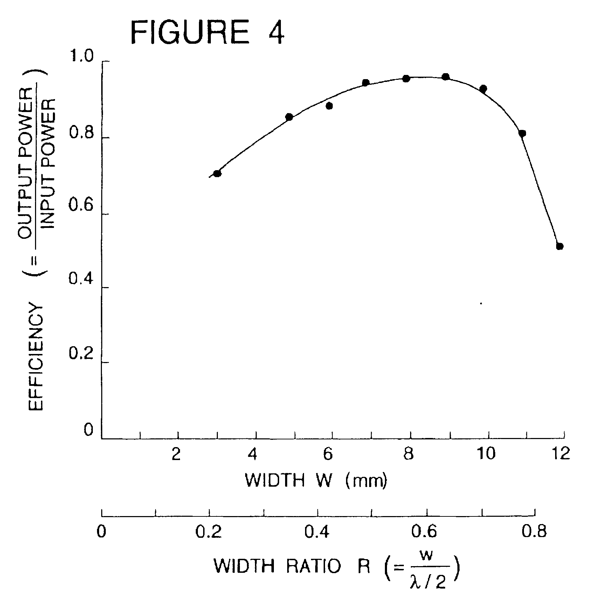

The characteristics of the piezoelectric transformer under this condition is shown in the graph of Figure 4, in which the axis of abscissas shows the width of the piezoelectric transformer and the axis of ordinates indicates the efficiency of the piezoelectric transformer. Here, the efficiency of the piezoelectric transformer is a ratio of an output power to an input power, and the width ratio R is "W"/($\lambda/2$).

It would be seen from Figure 4 that when the width ratio R is in the range of 0.5 to 0.7, the efficiency of the piezoelectric transformer is 93% to 95% and at maximum. The reason of this is considered to be that when the width "W" is made large, the output impedance of the piezoelectric transformer drops, so that the impedance matching with the back-light load is improved.

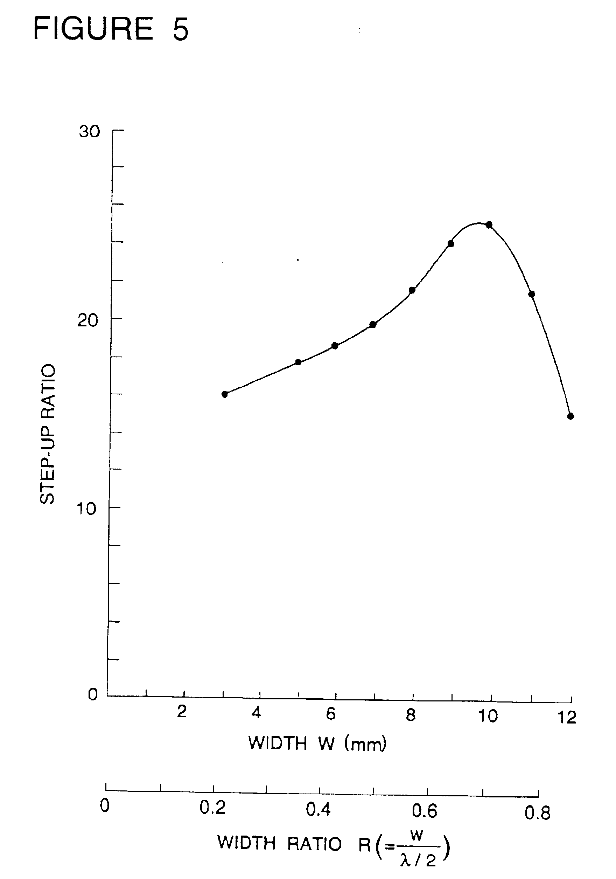

Referring to Figure 5, there is shown a graph illustrating a relation between the step-up ratio and the width in the piezoelectric transformer. The step-up ratio abruptly increases in the range of 8 mm$\leq$"W"$\leq$10 mm. The reason of this is considered to be that, in this range of 8 mm $\leq$ "W" $\leq$ 10 mm, the output impedance of the piezoelectric transformer is smaller than the load impedance.

Thus, it can be said from Figures 4 and 5 that if the width "W" of the piezoelectric transformer exceeds 10 mm, both of the efficiency and the step-up ratio drop. The reason of this is considered to be that, in addition to the longitudinal mechanical vibration in a lengthwise direction of the piezoelectric plate 1, the longitudinal mechanical vibration in a widthwise direction of the piezoelectric plate 1 occurs, which is a spurious mechanical vibration, and therefore, the transformer characteristics drops. Accordingly, it can be said that the width ratio R contains an optimum value. From a practical viewpoint of use, 0.5$\leq$R$\leq$0.8 is optimum. In this example, "W"=10 mm was adopted.

The above mentioned matter is attributable to the coupling of vibration mode based on the oscillator shape, and therefore, can be generally applied to all piezoelectric transformers having a plate like shape, without limitation of the oscillation mode order number.

Thus, the piezoelectric transformer having the total length of 42 mm, the width of 10 mm, and the thickness of 1 mm was used to light the back-light.

Then, with the third order mode resonance frequency of 115 KHz and the input of 22 V, the output voltage was 550 V and the output power was 3 W. The efficiency was 93 %, and the brightness on the light guide place was 2000 Cd/m$^2$.

At this time, since an electrostatic capacitance of the output of the piezoelectric transformer was 30 pF, the output impedance can be calculated to be about 85 KΩ from the above mentioned equation (1).

Namely, the output impedance was smaller than the impedance of 100 KΩ of the back-light as the load. Therefore, it can be said that a large step-up ratio could be obtained because the output impedance was smaller than the load impedance.

Embodiment 2

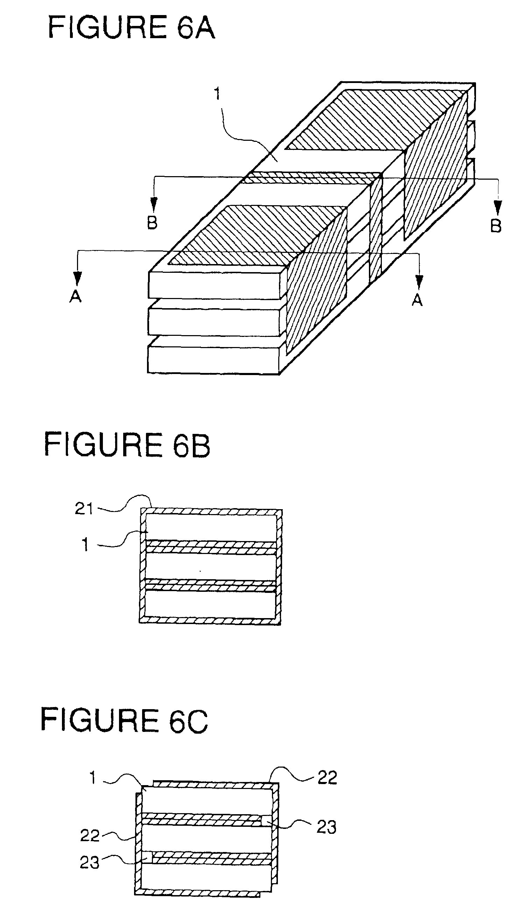

Referring to Figure 6A, there is shown a second embodiment of the piezoelectric transformer in accordance with the present invention.

The second embodiment was manufactured by stacking three piezoelectric plates 1 each of which is the same as the first embodiment excepting that the thickness of each piezoelectric plate 1 is 0.4 mm, and by electrically connecting the three piezoelectric plates 1 in parallel to each other but mechanically coupling the three piezoelectric plates 1 in series in a thickness direction, as shown in Figures 6A, 6B and 6C.

Namely, the generator section has an electrode 21 surrounding each of the three piezoelectric plates 1 as shown in Figure 6B. Therefore, the electrode 21 has the same potential. On the other hand, the driver section has a construction similar to a conventional stacked ceramic capacitor. Namely, the driver section has a pair of electrodes 22 electrically insulated from each other. For the mechanical coupling, an insulating epoxy resin bonding agent is applied between the piezoelectric plates 1 so that an insulating layer 23 is ensured as shown in Figure 6C so as to electrically insulate the electrodes 22 from each other.

When a pure resistance load of 100 KΩ was connected to this second embodiment, the output voltage of 500 V and the output power of 2.5 W were obtained with the resonance frequency of 110 KHz and the input of 8 V. In this embodiment, the output characteristics is most excellent in the range of 0.5≤R≤0.8.

As seen from the above, the piezoelectric transformer in accordance with the present invention is characterized in that, in order to improve the output characteristics of the piezoelectric transformer, the width ratio R is put in an optimum range of 0.5≤R≤0.8. With this feature, the step-up ratio can be made large while maintaining the conversion efficiency at a high value. Alternatively, it is possible to prevent the drop of the output which would be otherwise caused by the spurious oscillation (namely, a widthwise direction oscillation).

Furthermore, since the piezoelectric transformer in accordance with the present invention can have a large step-up ratio, if the piezoelectric transformer in accordance with the present invention is used in an inverter for driving the back-light of the color liquid crystal display, it is possible to reduce the required input voltage, and therefore, to realize the low voltage driving for the purpose of an energy-saving of electric instruments. In addition, since the piezoelectric transformer in accordance with the present invention has a high conversion efficiency, it is possible to elevate the efficiency of the inverter for driving the back-light of the color liquid crystal display, and therefore, to further facilitate the energy-saving.

In addition, since the piezoelectric transformer in accordance with the present invention can be realized by widening the width of the piezoelectric transformer, the inverter including the piezoelectric transformer can be made small both in size and in thickness. For example, as compared with the conventional solenoid transformer type inverter for driving the back-light of the color liquid crystal display, the required area can be reduced by 50% and the required height can be reduced by 40%.

The invention has thus been shown and described with reference to the specific embodiments. However, it should be noted that the present invention is in no way limited to the details of the illustrated structures but changes and modifications may be made within the scope of the appended claims.

**Claims**

1. A piezoelectric transformer comprising a piezoelectric plate in the form of an elongated plate and electrodes (2A, 2B, 5A, 5B) formed theron, said piezoelectric plate being divided into a pair of driver sections (3A, 3B) and at least one generator section (6) which are continuous and integral with each other so as to form a single piezoelectric plate,
   **characterized** in that
   the ratio "R" of the width "W" of said piezoelectric plate to the resonance half wavelength "λ/2" of the longitudinal mechanical oscillation in a lengthwise direction of said piezoelectric plate is in the range of 0.5≤R≤0.8.

2. A piezoelectric transformer according to claim 1 wherein

   said pair of driver sections (3A, 3B) being formed of two end regions of said piezoelectric plate containing a mechanical resonance node in an oscillation mode of the three or more odd number times of 1/2 of a resonance wavelength λ of the longitudinal mechanical oscillation in length of said piezoelectric plate,
   said at least one generator section (5) being formed of a central region of said piezoelectric plate containing a mechanical resonance node in said three or more odd number times oscillation mode,
   said driver sections being polarized in thickness direction, and
   said driver sections (3A, 3B) having a distance of λ/2 from the corresponding end of said piezoelectric plate.

3. A piezoelectric transformer as claimed in claim 2 wherein the width "W" of said piezoelectric plate is not greater than 10 mm.

4. A piezoelectric transformer as claimed in claim 2 wherein the width "W" of said piezoelectric plate is not less than 8 mm.

5. A piezoelectric transformer as claimed in claim 2 wherein the width "W" of said piezoelectric plate is not greater than 10 mm but not less than 8 mm.

6. A piezoelectric transformer as claimed in claim 2 wherein said driver sections (3A, 3B) are polarized in the same thickness direction to each other.

**Patentansprüche**

1. Piezoelektrischer Transformator mit einer piezoelektrischen Platte in Form einer länglichen Platte und Elektroden (2A, 2B, 5A, 5B) die darauf ausgebildet sind, wobei die piezoelektrische Platte in zwei Treiberabschnitte (3a, 3b) und zumindest einen Generatorabschnitt (6) unterteilt ist, die fortgesetzt und einstückig miteinander sind und eine einzelne piezoelektrische Platte bilden,
dadurch **gekennzeichnet**, daß
das Verhältnis "R" der Breite "W" der piezoelektrischen Platte zur Resonanzhalbwellenlänge "λ/2" der mechanischen Längsoszillation in Längenrichtung der piezoelektrischen Platte im Bereich von $0,5 \leq R \leq 0,8$ liegt.

2. Piezoelektrischer Transformator nach Anspruch 1, wobei

die beiden Treiberabschnitte (3a, 3b), die in zwei Endbereichen der piezoelektrischen Platte ausgebildet sind, einen mechanischen Resonanzknoten in einem Oszillationsmodus von drei oder einem ungeradzahligen Vielfachen von 1/2 einer Resonanzwellenlänge λ der mechanischen Längsoszillation in der Länge der piezoelektrischen Platte enthalten, zumindest ein Generatorabschnitt (5) in einem Mittenbereich der piezoelektrischen Platte gebildet ist, der einen mechanischen Resonanzknoten in dem dreifachen oder mehrfachen ungeradzahligen Oszillationsmodus enthält,
die Treiberabschnitte in Dickenrichtung polarisiert sind und
die Treiberabschnitte (3a, 3b) einen Abstand von λ/2 von dem entsprechenden Ende der piezoelektrischen Platte aufweisen.

3. Piezoelektrischer Transformator nach Anspruch 2, wobei die Breite "W" der piezoelektrischen Platte nicht größer als 10 mm ist.

4. Piezoelektrischer Transformator nach Anspruch 2, wobei die Breite "W" der piezoelektrischen Platte nicht weniger als 8 mm beträgt.

5. Piezoelektrischer Transformator nach Anspruch 2, wobei die Breite "W" der piezoelektrischen Platte nicht mehr als 10 mm, aber nicht weniger als 8 mm beträgt.

6. Piezoelektrischer Transformator nach Anspruch 2, wobei die Treiberabschnitte (3a, 3b) in derselben Dickenrichtung polarisiert sind.

**Revendications**

1. Transformateur piézoélectrique comprenant une plaque piézoélectrique sous la forme d'une plaque allongée et des électrodes (2A, 2B, 5A, 5B) formées sur celle-ci, ladite plaque piézoélectrique étant divisée en deux sections de commande (3A, 3B) et au moins une section de générateur (6) qui sont continues et d'un seul tenant les unes avec les autres afin de former une plaque piézoélectrique unique,
caractérisé en ce que
le rapport "R" de la largeur "W" de ladite plaque piézoélectrique sur la demi-longueur d'onde de résonance "λ/2" de l'oscillation mécanique longitudinale dans le sens de la longueur de ladite plaque piézoélectrique est compris dans la plage de $0,5 \leq R \leq 0,8$.

2. Transformateur piézoélectrique selon la revendication 1, dans lequel

lesdites deux sections de commande (3A, 3B) sont constituées de deux régions d'extrémité de ladite plaque piézoélectrique contenant un noeud de résonance mécanique dans un mode d'oscillation des trois fois ou un nombre impair supérieur de fois de la moitié d'une longueur d'onde de résonance λ de l'oscillation mécanique longitudinale en longueur de ladite plaque piézoélectrique,
ladite au moins une section de générateur (5) est constituée d'une région centrale de ladite plaque piézoélectrique contenant un noeud de résonance mécanique dans ledit mode d'oscillation de trois fois ou un nombre impair supérieur de fois,
lesdites sections de commande sont polarisées dans le sens de l'épaisseur, et
lesdites sections de commande (3A, 3B) sont à une distance de λ/2 de l'extrémité correspondante de ladite plaque piézoélectrique.

3. Transformateur piézoélectrique selon la revendication 2, dans lequel la largeur "W" de ladite plaque piézoélectrique n'est pas supérieure à 10 mm.

4. Transformateur piézoélectrique selon la revendication 2, dans lequel la largeur "W" de ladite plaque piézoélectrique n'est pas inférieure à 8 mm.

5. Transformateur piézoélectrique selon la revendication 2, dans lequel la largeur "W" de ladite plaque piézoélectrique n'est pas supérieure à 10 mm, mais pas inférieure à 8 mm.

6. Transformateur piézoélectrique selon la revendication 2, dans lequel lesdites sections de commande (3A, 3B) sont polarisées dans le même sens de l'épaisseur l'une par rapport à l'autre.

FIGURE 1 PRIOR ART

2B INPUT ELECTRODE

7 OUTPUT ELECTRODE AND SUPPORT

1 PIEZOELECTRIC PLATE

10

$V_{in}$

3B INPUT ELECTRODE

9

$V_{out}$

5B DRIVER SECTION

6 GENERATION SECTION

2A INPUT ELECTRODE

10

9

3A

$V_{out}$

5A DRIVER SECTION

$V_{in}$

FIGURE 2   PRIOR ART

STEP-UP RATIO (y-axis)

IMPEDANCE OF CONNECTED LOAD (Ω)

EP 0 706 227 B1

# FIGURE 3

2B INPUT ELECTRODE

7 OUTPUT ELECTRODE AND SUPPORT

1 PIEZOELECTRIC PLATE

10

$V_{in}$

3B INPUT ELECTRODE

9

5B DRIVER SECTION

$V_{out}$

6 GENERATION SECTION

2A INPUT ELECTRODE

10

$V_{out}$

9

3A

5A DRIVER SECTION

$V_{in}$

FIGURE 4

# FIGURE 5

# FIGURE 6A

1

B

B

A

A

# FIGURE 6B

21

1

# FIGURE 6C

1

22

22

23

23